(19) Europäisches Patentamt
European Patent Office
Office européen des brevets

(11) **EP 2 280 330 A1**

(12) **EUROPÄISCHE PATENTANMELDUNG**

(43) Veröffentlichungstag:
**02.02.2011 Patentblatt 2011/05**

(51) Int Cl.:
*G06F 1/03* $^{(2006.01)}$     *H03B 21/02* $^{(2006.01)}$

(21) Anmeldenummer: **10006872.5**

(22) Anmeldetag: **02.07.2010**

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(30) Priorität: **10.07.2009 DE 102009032811**

(71) Anmelder: **KROHNE Messtechnik GmbH**
**47058 Duisburg (DE)**

(72) Erfinder: **Gerding, Michael, Dr.**
**44805 Bochum (DE)**

(74) Vertreter: **Gesthuysen, von Rohr & Eggert**
**Patentanwälte**
**Huyssenallee 100**
**45128 Essen (DE)**

(54) **Frequenzsynthesizer für ein Füllstandsmessgerät und Füllstandsmessgerät**

(57)    Dargestellt und beschrieben ist ein Frequenzsynthesizer, insbesondere für einen Zeitbasisgenerator eines Füllstandsmessgeräts, das nach dem Radarprinzip arbeitet, mit wenigstens einem ersten Ausgang (2) zur Ausgabe eines ersten Frequenzsignals, mit wenigstens einem zweiten Ausgang (3) zur Ausgabe eines zweiten Frequenzsignals, und mit einem Referenzoszillator (4) zur Erzeugung eines Referenzfrequenzsignals, wobei das erste Frequenzsignal und das zweite Frequenzsignal eine geringe Differenzfrequenz zueinander aufweisen, wobei das erste Frequenzsignal durch Zusammenwirken des Referenzoszillators (4) mit einem Direct-Digital-Synthesizer (5) erzeugbar ist.

Mit dem Frequenzsynthesizer lassen sich besonders störarm ein erstes Frequenzsignal und ein zweites Frequenzsignal mit geringer Differenzfrequenz zueinander erzeugen, indem das zweite Frequenzsignal von dem Referenzoszillator (4) ohne Zwischenschaltung eines Direct-Digital-Synthesizers abgeleitet ist und der Direct-Digital-Synthesizer (5) so betrieben ist, dass nur ein zumindest partiell minimiertes Störspektrum erzeugt wird.

Fig. 1

EP 2 280 330 A1

**Beschreibung**

Die Erfindung betrifft einen Frequenzsynthesizer, insbesondere für einen Zeitbasisgenerator eines Füllstandsmessgeräts, das nach dem Radarprinzip arbeitet, mit wenigstens einem ersten Ausgang zur Ausgabe eines ersten Frequenzsignals, mit wenigstens einem zweiten Ausgang zur Ausgabe eines zweiten Frequenzsignals, und mit einem Referenzoszillator zur Erzeugung eines Referenzfrequenzsignals, wobei das erste Frequenzsignal und das zweite Frequenzsignal eine geringe Differenzfrequenz zueinander aufweisen, wobei das erste Frequenzsignal durch Zusammenwirken des Referenzoszillators mit einem Direct-Digital-Synthesizer erzeugbar ist. Ferner betrifft die Erfindung auch ein Füllstandsmessgerät, das nach dem Radarprinzip arbeitet mit einem Frequenzsynthesizer zur Erzeugung eines ersten Frequenzsignals - Abtastsignal - und zur Erzeugung eines zweiten Frequenzsignals - Sendesignal -.

Derartige Frequenzsynthesizer sind seit einiger Zeit bekannt, insbesondere aus dem Bereich der Messtechnik. Frequenzsynthesizer, die zwei Frequenzsignale mit nur kleiner Differenzfrequenz zueinander aufweisen, werden häufig als Zeitbasisgenerator für Füllstandsmessgeräte, die nach dem Radarprinzip arbeiten, verwendet. Der hier beschriebene Frequenzsynthesizer ist auch für andere Anwendungsfälle geeignet, jedoch lassen sich die an Frequenzsynthesizer gestellten technischen Anforderungen anhand von Abstandsmessungen auf Radarbasis besonders gut erklären.

Füllstandsmessgeräte, die nach dem Radarprinzip arbeiten, emittieren in den beobachteten Raumabschnitt elektromagnetische Wellen, die typischerweise Frequenzen im MHz- bis GHz-Bereich aufweisen. Diese elektromagnetischen Wellen werden an dem zu erfassenden Füllgut reflektiert und gelangen zu dem Füllstandsmessgerät zurück, wo sie wiederum erfasst werden. Die Laufzeit des Sendesignals ist dabei proportional zum Abstand des Füllstandsmessgeräts - genauer des Messumformers des Füllstandsmessgeräts - von dem Füllgut. Aufgrund der hohen Ausbreitungsgeschwindigkeit elektromagnetischer Wellen nahe der Lichtgeschwindigkeit in dem überwachten Raumabschnitt ergeben sich sehr geringe Laufzeiten des elektromagnetischen Sendesignals, die ggf. im Bereich von wenigen Nanosekunden liegen können, wenn auch Abstände im Bereich von einigen zehn Zentimetern erfasst werden sollen.

Die Erfassung solch geringer Laufzeiten stellt höchste Anforderungen an die zur Anwendung kommende Messtechnik, wobei es keinen Unterschied macht, ob die emittierten elektromagnetischen Wellen über eine Antenne abgestrahlt werden, oder ob die Radarmessung anhand einer geführten Welle (Time Domain Reflectometry) erfolgt.

Um eine reflektierte periodische elektromagnetische Welle messtechnisch korrekt erfassen zu können, ist unter Verwendung eines im Echtzeit arbeitenden Abtastverfahrens eine Abtastrate notwendig, die mehr als der doppelten Frequenz des Sendesignals entspricht (Nyquist-Kriterium). Zur Abtastung von reflektierten Mikrowellen mit den verbundenen geringen Signallaufzeiten macht dies Abtastfrequenzen notwendig, die nur mit ausgesprochen hohem schaltungstechnischen Aufwand bewältigt werden können.

Um derartig schnelle Vorgänge auch mit weniger aufwendigen Mitteln erfassen zu können, ist aus dem Stand der Technik bekannt, nicht ein einziges reflektiertes Sendesignal mit einer hohen Abtastrate zu erfassen, sondern eine Vielzahl von reflektierten Sendesignalen nacheinander mit einer von Abtastschritt zu Abtastschritt zeitlich leicht versetzten Abtastung zu erfassen, wobei unterstellt wird, dass sich an der messtechnisch zu erfassenden Situation während der Abtastung der vielen verschiedenen Sendeimpulse nichts ändert, dass während der Messung also ein stationärer Zustand beobachtet wird. Eine solche Abtastung ist auch als "serielle Abtastung" oder als "Abtastung unter Zeitdehnung" bekannt.

Zur Realisierung einer solchen seriellen Abtastung werden Frequenzsynthesizer verwendet, die an ihrem ersten Ausgang ein erstes Frequenzsignal ausgeben und an ihrem zweiten Ausgang ein zweites Frequenzsignal ausgeben, wobei das erste Frequenzsignal und das zweite Frequenzsignal nur eine geringe Frequenzdifferenz zueinander aufweisen. Bei dem zweiten Frequenzsignal handelt es sich - um beim Beispiel der Radar-Abstandsmessung zu bleiben - um das emittierte und später reflektierte Sendesignal eines Füllstandsmessgeräts. Das erste Frequenzsignal wird zur fortwährend weiter verschobenen Abtastung - bzw. zur Festlegung des Zeitpunktes einer solchen Abtastung - des zweiten Frequenzsignals verwendet, so dass das erste Frequenzsignal eine gegenüber dem zweiten Frequenzsignal geringfügig verschobene Frequenz aufweist. Wenn das erste Frequenzsignal eine Frequenz $f_1$ aufweist und das zweite Frequenz-signal eine Frequenz $f_2$ aufweist, unterscheidet sich die Frequenz $f_1$ des ersten Frequenzsignals und die Frequenz $f_2$ des zweiten Frequenzsignals durch die Differenzfrequenz $\Delta f$ gemäß

$$\Delta f = | f_2 - f_1 |. \qquad (1)$$

Das Verhältnis der Frequenz $f_2$ des zweiten Frequenzsignals zu der Differenzfrequenz $\Delta f$ ist der Faktor, um den das abzutastende reflektierte Sendesignal gedehnt und damit im Frequenzbereich entsprechend gestaucht wird, wodurch letztlich die Verarbeitung des empfangenen Signals in einem niedrigeren Frequenzbereich als dem des Sendesignals möglich ist. In der Praxis liegt die Differenzfrequenz $\Delta f$ zwischen dem ersten Frequenzsignal und dem zweiten Frequenzsignal häufig im Bereich von - nur einigen - 100 Hz, teilweise sogar nur bei einigen wenigen Hertz, also in einem Frequenzbereich, in dem die meßtechnische Erfassung des Sendesignals ohne weiteres möglich ist.

Bei Verfahren zur Entfernungsmessung aufgrund der Ermittlung einer Laufzeit mit serieller Abtastung hängt die Genauigkeit der ermittelten Entfernung direkt mit der Genauigkeit zusammen, mit der die Differenzfrequenz $\Delta f$ eingehalten werden kann, so dass eine hohe Meßgenauigkeit hier nur durch eine hohe Stabilität bei der Differenzfrequenz erzielt werden kann.

Bekannte Frequenzsynthesizer arbeiten meist mit Phasenregelschleifen (Phase-Locked-Loop), mit denen bestimmte Phasen und Frequenzversätze eingestellt werden können, wobei derartige Schaltungen vergleichsweise aufwendig sind, da sie beispielsweise abstimmbare Oszillatoren (z. B. VCO) benötigen. Zudem haben derartige Frequenzsynthesizer eine vergleichsweise große Einschwingzeit, um eine stabile Differenzfrequenz zu liefern, bzw. um auf eine andere Differenzfrequenz zu wechseln.

Es ist ferner grundsätzlich bekannt, einen Frequenzsynthesizer unter Verwendung von Direct-Digital-Synthesizern zu realisieren, die üblicherweise als integrierte Halbleiterschaltungen zur Verfügung stehen und einen frequenz- und phaseneinstellbares Ausgangssignal erzeugen können, das in weiten Grenzen und mit hoher Geschwindigkeit variiert werden kann. Es sind Ansätze bekannt, bei denen das erste Frequenzsignal und das zweite Frequenzsignal jeweils durch separate Direct-Digital-Synthesizer generiert werden.

Bei einem Direct-Digital-Synthesizer handelt es sich um ein digitales schaltungstechnisches Bauteil, das ausgangsseitig üblicherweise einen Digital/Analog-Wandler aufweist und das es gestattet, einen frequenz- und phaseneinstellbares Ausgangssignal zu erzeugen, wobei der Direct-Digital-Synthesizer selbst mit einem bestimmten Frequenzsignal getaktet werden kann. Im Wesentlichen weisen Direct-Digital-Synthesizer einen sogenannten Phasenakkumulator auf, der nichts anderes als ein getakteter Zähler ist, der einen Phasenspeicher ansteuert, wobei in dem Phasenspeicher die Amplitudenwerte des zu der jeweiligen Phase gehörenden Frequenzsignals abgelegt sind, also beispielsweise die Amplitudenwerte einer Sinusschwingung. Durch getaktetes Hochzählen der Phase im Phasenakkumulator gibt der Phasenspeicher die mit der Phase entsprechende Amplitude des Frequenzsignals in digitaler Form auf einen Digital/Analog-Wandler, der diesen Wert in ein analoges Spannungssignal wandelt. Häufig sind die Phasenakkumulatoren steuerbar, indem ihnen vorgebbar ist, wie viele abgelegte Phasenwerte bei jeder Inkrementierung übersprungen werden sollen. Diese Eigenschaft ist dann über die Vorgabe eines Sprungswortes parametrierbar, wobei der Phasenakkumulator dann dem Grunde nach als variabler Modulus-Zähler arbeitet.

Abgesehen davon, dass die Lösung zur Realisierung eines Frequenzsynthesizers unter Verwendung zweier Direct-Digital-Synthesizer vergleichsweise kostenintensiv ist, weist sie auch technische Nachteile auf, die mit den von Direct-Digital-Synthesizern üblicherweise erzeugten spektralen Störungen zusammenhängen.

Es ist daher Aufgabe der vorliegenden Erfindung, einen Frequenzsynthesizer und ein Füllstandsmessgerät unter Verwendung von Direct-Digital-Synthesizern bereitzustellen, der bzw. das die oben genannten Nachteile - zumindest teilweise - vermeidet.

Ausgehend von dem eingangs beschriebenen Frequenzsynthesizer ist die zuvor hergeleitete und aufgezeigte Aufgabe dadurch gelöst, dass das zweite Frequenzsignal von dem Referenzoszillator ohne Zwischenschaltung eines weiteren Direct-Digital-Synthesizers abgeleitet ist und der Direct-Digital-Synthesizer so betrieben ist, dass nur ein zumindest partiell minimiertes Störspektrum erzeugt wird.

Erfindungsgemäß ist erkannt worden, dass ein unter Verwendung von Direct-Digital-Synthesizern realisierter Frequenzsynthesizer in ganz erheblichem Maße dazu neigt, nicht nur ein Signal - in der Regel eine Sinus-Schwingung - mit der gewünschten Frequenz zu erzeugen, sondern üblicherweise auch Störsignale bei anderen Frequenzen erzeugt, die mehr oder weniger weit beabstandet von dem eigentlich ausgegebenen Frequenzsignal liegen können. Erfindungsgemäß ist ferner erkannt worden, dass insbesondere die Verwendung von zwei oder mehreren Direct-Digital-Synthesizern - insbesondere gleicher Bauart - innerhalb einer Frequenzsynthesizer-Schaltung ungeeignet ist, insbesondere dann, wenn das erste Frequenzsignal und das zweite Frequenzsignal nur eine geringe Differenzfrequenz zueinander aufweisen, wie dies ja gefordert ist. Der erfindungsgemäße Frequenzsynthesizer bietet durch die Verwendung nur eines einzigen Direct-Digital-Synthesizers die Möglichkeit, diesen Direct-Digital-Synthesizer in einem ausgewählten Modus so zu betreiben, dass das erzeugte Störspektrum zumindest partiell minimiert ist, wodurch frequenzmäßig eng benachbarte Frequenzsignale mit einem guten Signal-zu-Rausch-Verhältnis erzeugt werden können bei gleichzeitiger Nutzung der Vorzüge von Direct-Digital-Synthesizern, wie z. B. einem nahezu verzögerungsfreien Frequenzwechsel.

Erfindungsgemäß ist ferner erkannt worden, dass es verschiedene Möglichkeiten gibt, den in dem Frequenzsynthesizer vorgesehenen Direct-Digital-Synthesizer so zu betreiben, dass das von dem Direct-Digital-Synthesizer erzeugte Störspektrum zumindest partiell minimiert ist; die partielle Minimierung erfolgt entweder hinsichtlich des Quantisierungsrauschens des verwendeten Digital/Analog-Wandlers und/oder hinsichtlich einer störlinienfreien Phasentrunkierung, was nachfolgend im Detail erläutert ist.

Gemäß einer ersten bevorzugten Ausgestaltung des erfindungsgemäßen Frequenzsynthesizers wird eine partielle Minimierung des Störspektrums dadurch erreicht, dass ein von dem Direct-Digital-Synthesizer umfasster Digital/Analog-Wandler bei maximaler Auflösung betrieben wird. Durch diese Maßnahme wird erreicht, dass der Effekt des bei jedem Digital/AnalogWandler vorhandenen Quantisierungsfehlers, nämlich das mit dem Quantisierungsfehler verbundene Quantisierungsrauschen des Ausgangssignals minimiert wird. Durch die Verwendung der maximalen Auflösung des Digital/Analog-Wandlers kann mit den vorhandenen Mitteln des eingesetzten Digital/Analog-Wandlers eine bestmögliche Annäherungen des Frequenzsignals an ein ideales Sinussignal erzielt werden, so dass die insgesamt in das Störspektrum eingehende Leistung minimiert wird und infolgedessen auch ein partiell minimiertes Störspektrum des Frequenzsynthesizers realisiert ist.

Eine weitere partielle Minimierung des Störspektrums lässt sich gemäß einer weiteren bevorzugten Ausgestaltung des erfindungsgemäßen Frequenzsynthesizers dadurch realisieren, dass der von dem Direct-Digital-Synthesizer umfasste Digital/Analog-Wandler bei einer Frequenz in Überabtastung betrieben wird, insbesondere bei maximaler Frequenz betrieben wird. Diese Ausgestaltung beruht auf der Erkenntnis, dass die bei einer bestimmten Quantisierung vorhandene Rauschleistung des Digital/Analog-Wandlers zwar unabhängig von der Frequenz ist, bei der der Digital/Analog-Wandler betrieben wird, sich diese bei fester Betriebsfrequenz betragsmäßig unveränderliche Störleistung spektral aber in Abhängigkeit von der Betriebsfrequenz des Digital/Analog-Wandlers verteilt. Bei zunehmender Abtastfrequenz nimmt auch die Ausdehnung des Störfrequenzspektrums zu, im Gegenzug nimmt aber die Amplitude der verteilten Störlinien ab, so dass in einem betrachteten Frequenzbereich die auf diesen Frequenzbereich entfallende Störleistung mit zunehmender Abtastfrequenz abnimmt. Durch die vorgeschlagene Maßnahme wird also erreicht, dass die bei einer bestimmten Frequenz vorliegende Stör- bzw. Rauschleistung bei zunehmender Abtastfrequenz kleiner wird und damit der Störabstand zwischen Nutz- und Störsignal (Verhältnis von Nutzsignalleistung zu Quantisierungs-Rauschleistung) partiell maximiert wird.

Eine ganz besonders bevorzugte Ausgestaltung der Erfindung ist **dadurch gekennzeichnet, dass** der Direct-Digital-Synthesizer mit solchen Phasensprüngen betrieben wird, die keine Störlinien aufgrund von Phasentrunkierung erzeugen.

Üblicherweise werden Direct-Digital-Synthesizer mit einer niedrigeren Phasenauflösung betrieben als es theoretisch möglich ist. Dies geschieht beispielsweise, um einen kleineren Phasenspeicher vorsehen zu können, als dies bei maximaler Ausschöpfung der Auflösung des Phasenakkumulators notwendig wäre. Wenn beispielsweise der Phasenakkumulator über n-Bit verfügt, dann werden zur Ausgabe der entsprechenden Werte aus dem Phasenspeicher nur die höchstwertigen m-Bits (also die m most-significant-bits, MSBs) - zur tatsächlichen Phasenauflösung genutzt, die unteren (n-m)-Bits bleiben unberücksichtigt; die geringstwertigen (n-m)-Bits des Phasenakkumulators werden also abgeschnitten, mit anderen Worten "trunkiert". Die durch die beschriebene Trunkierung des Phasenakkumulators sich ergebenden Phasenwerte weichen zu den Inkrimitierungszeitpunkten im Regelfall von denjenigen Winkelwerten ab, die sich unter Berücksichtigung der vollen Auflösung des Phasenakkumulators und des Phasenspeichers ergäben, wobei sich die ergebenden Fehler periodisch wiederholen. Dieser Effekt ist zudem abhängig von dem Sprungwort, mit dem der Direct-Digital-Synthesizer zusätzlich parametrierbar ist und das angibt, wie viele Werte bei einem Inkrement in dem Phasenakkumulator übersprungen werden. Die durch Phasentrunkierung verursachten periodischen Fehler führen jedenfalls aufgrund der Periodizität zu Störlinien im Frequenzspektrum; erfindungsgemäß werden nun solche Trunkierungen verwendet, die - ausnahmsweise - keine periodischen Fehler erzeugen.

Nach einer besonders bevorzugten Ausgestaltung der Erfindung wird bei einem Frequenzsynthesizer mit Direct-Digital-Synthesizer, der einen n-Bit Phasenakkumulator und einen von dem Phasenakkumulator angesteuerten Phasenspeicher umfasst, wobei der Phasenakkumulator mit einem n-Bit Sprungwort parametrierbar ist, wobei nur die m Most-Significant-Bits (MSBs) des Phasenakkumulators zur Ansteuerung des Phasenspeichers genutzt werden, das n-Bit-Sprungwort so gewählt, dass an der Bitposition (n-m) eine 1 vorgesehen ist und alle niedrigeren Bitpositionen mit Nullen besetzt sind. Nur für diese speziellen Sprungworte können Störlinien aufgrund Phasentrunkierung vermieden werden, was wiederum verdeutlicht, dass es praktisch nicht möglich ist, bekannte Frequenzsynthesizer mit zwei Direct-Digital-Synthesizern zur Erzeugung von zwei Frequenzsignalen mit geringer Differenzfrequenz zu verwenden, da dies unter dem vorgenannten Kriterium der von periodischen Fehlern freien Phasentrunkierung praktisch nicht störlinienfrei möglich ist.

In einer ganz besonders vorteilhaften Ausgestaltung der Erfindung wird dem Direct-Digital-Synthesizer wenigstens ein Bandpass nachgeschaltet, der außerhalb seines Duchlassbereiches alle von ihm übermittelten Signale stark dämpft bzw. unterdrückt. Dies ermöglicht es, den Direct-Digital-Synthesizer sogar mit solchen Phasensprüngen zu betreiben, die zwar Störlinien aufgrund Phasentrunkierung erzeugen, jedoch nur solche Störlinien, die in den Sperrbereich des dem Direct-Digital-Synthesizer nachgeschalteten Bandpasses fallen. Dadurch kommen erheblich mehr Frequenzen für den Direct-Digital-Synthesizer in Frage als bei ausschließlicher Auswahl von Phasensprüngen, die keine Störlinien aufgrund von Phasentrunkierung erzeugen, wie dies zuvor gefordert worden ist. Geeignete Sprungworte für einen derartigen Betrieb können beispielsweise auch experimentell gefunden werden, indem das Sprungwort in dem Gewünschten Frequenzbereich systematisch variiert wird und das Störlinienspektrum jeweils erfasst wird, bis ein Störlinienspektrum nur Störlinien bei Frequenzen jenseits des Durchlassbereiches des Bandpasses aufweist.

In weiteren bevorzugten Ausführungsbeispielen, die in der Figurenbeschreibung näher erläutert werden, werden ein oder mehrere - bevorzugt programmierbare - Frequenzteiler eingesetzt. Neben dem damit gewonnenen zusätzlichen Freiheitsgrad bei der Auswahl einer geeigneten Frequenzkombination durch die Nutzung eines oder mehrerer Frequenzteiler, wird ferner ein verbessertes Signal-zu-Rausch-Verhältnis erzielt. Der zusätzlich gewonnene Störlinienabstand ergibt sich beispielsweise für den Teilungsfaktor M zu 20·log (M) in dB. Die Störsignale werden - wie zuvor beschrieben - durch die Digital/Analog-Wandler des Direct-Digital-Synthesizers bzw. durch periodische Fehler durch die Phasentrunkierung erzeugt, es kann sich aber auch um Phasenrauschen handeln, dass mit dem Einsatz des Referenzoszillators in Zusammenhang steht, da der Referenzoszillator - und damit das Referenzfrequenzsignal- im Regelfall nicht nur die gewünschte Referenzfrequenz aufweist, sondern noch weitere - unerwünschte - Frequenzanteile liefert, wobei diese Frequenzanteile je nach Gütefaktor des Oszillators unterschiedlich ausgeprägt sind.

Bei weiteren vorteilhaften Ausgestaltungen der Erfindung wird der Frequenzsynthesizer bei einer möglichst großen bzw. maximalen Frequenz des Direct-Digital-Synthesizers betrieben, was auch verschiedenen, bereits beschriebenen Gründen vorteilhaft ist, jedoch auch deshalb vorteilhaft ist, weil unter Einsatz weiterer Frequenzteiler oder von Frequenzteilern mit größeren Teilerfaktoren zur Einstellung der gewünschten Frequenzsignale das Signal-Zu-Rausch-Verhältnis noch weiter verbessert werden kann.

Nach einer unabhängigen Lehre der Erfindung ist die eingangs beschriebene Aufgabe bei einem Füllstandsmessgerät, das nach dem Radarprinzip arbeitet und einen Frequenzsynthesizer zur Erzeugung eines ersten Frequenzsignals - Abtastsignal - und zur Erzeugung eines zweiten Frequenzsignals - Sendesignal - aufweist, dadurch gelöst, dass der Frequenzsynthesizer in der vorgeschriebenen Art realisiert ist.

Im Einzelnen gibt es nun verschiedene Möglichkeiten, den erfindungsgemäßen Frequenzsynthesizer und das erfindungsgemäße Füllstandsmessgerät auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung zeigen

Fig. 1  ein erstes Ausführungsbeispiel eines erfindungsgemäßen Fre- quenzsynthesizers mit einem ersten Direct-Digital-Synthesizer und

Fig. 2  ein Ausführungsbeispiel eines erfindungsgemäßen Frequenzsyn- thesizers mit einem Mischer.

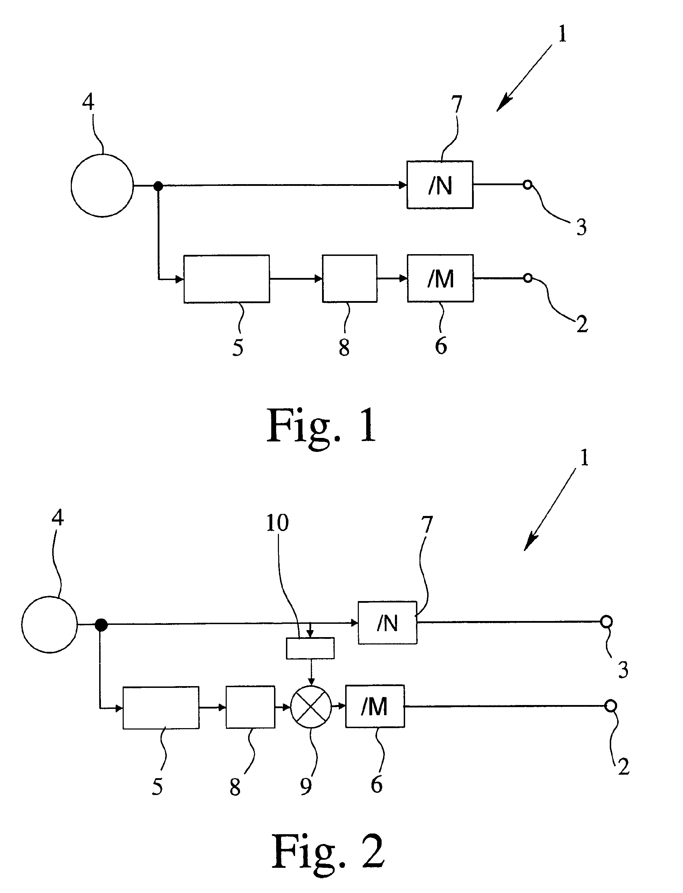

Die in den Fig. 1 und 2 dargestellten Frequenzsynthesizer 1 sind vorgesehen für einen Zeitbasisgenerator eines nicht näher dargestellten Füllstandsmessgeräts, das nach dem Radarprinzip arbeitet. Den Frequenzsynthesizern 1 ist gemeinsam, dass sie einen ersten Ausgang 2 zur Ausgabe eines ersten Frequenzsignals und einen zweiten Ausgang 3 zur Ausgabe eines zweiten Frequenzsignals aufweisen. Ferner weisen sie jeweils einen Referenzoszillator 4 zur Erzeugung eines Referenzfrequenzsignals auf. Das erste Frequenzsignal und das zweite Frequenzsignal weisen eine geringe Differenzfrequenz von wenigen Hertz zueinander auf, so wie sie beispielsweise benötigt wird, um eine serielle Abtastung mit Zeitdehnung zu realisieren, wie sie eingangs beschrieben worden ist. Den dargestellten Frequenzsynthesizern 1 ist auch gemeinsam, dass das erste Frequenzsignal am ersten Ausgang 2 durch Zusammenwirken des Referenzoszillators 4 mit einem ersten Direct-Digital-Synthesizer 5 erzeugbar ist, indem nämlich der erste Direct-Digital-Synthesizer 5 zwischen dem Referenzoszillator 4 und dem ersten Ausgang 2 vorgesehen ist.

Bei den dargestellten Frequenzsynthesizern 1 ist das zweite Frequenzsignal von dem Referenzoszillator 4 ohne Zwischenschaltung eines - weiteren - Direct-Digital-Synthesizers abgeleitet und der vorhandene Direct-Digital-Synthesizer 5 wird so betrieben, dass das aus verschiedenen Gründen bei dem Betrieb eines Direct-Digital-Synthesizers unvermeidbare Störspektrum zumindest partiell minimiert ist.

Als eine erste Maßnahme zur partiellen Minimierung des Störspektrums wird der von den Direct-Digital-Synthesizern 5 umfasste und im Einzelnen aber nicht mehr dargestellte Digital/Analog-Wandler bei maximaler Auflösung betrieben, so dass das Quantisierungsrauschen minimal und damit der Störabstand, also das Verhältnis von Nutzsignalleistungen und Quantisierungs-rauschleistung maximal ist, was in der bei größtmöglicher Quantisierung bestmöglichen Annäherung des erzeugten Direct-Digital-Synthesizer-Ausgangssignals an ein ideales - und damit störfrequenzfreies - Sinussignal begründet ist.

Als eine weitere Maßnahme ist bei den in den Fig. 1 und 2 dargestellten Direct-Digital-Synthesizern 5 realisiert, dass der von den Direct-Digital-Synthesizern 5 umfasste Digital/Analog-Wandler bei einer Frequenz in Überabtastung betrieben wird, insbesondere bei maximaler Frequenz betrieben wird. Dadurch ändert sich zwar nichts an der insgesamt durch Quantisierungseffekte erzeugte Rauschleistung, jedoch wird diese auf einen größeren Frequenzbereich verteilt als bei einer geringeren Abtastrate, so dass die auf einzelne Frequenzen fallende Rauschleistung relativ geringer ist als bei einer geringeren Abtastrate. Dies ist insbesondere dann vorteilhaft, wenn beispielsweise mit einem Bandpass große Frequenzbereiche jenseits der interessierenden Frequenz ausgeblendet werden und damit ein relativ großer Teil der Quantisierungs-Rauschleistung ausgeblendet werden kann.

Eine ganz besondere Bedeutung der Minimierung des Störspektrums kommt der bei beiden dargestellten Frequenzsynthesizern 1 realisierten Maßnahme zu, dass nämlich nur solche Phasensprünge mit den eingesetzten Direct-Digital-Synthesizern 5 verwendet werden, die keine Störlinien in Zusammenhang mit der eingangs erläuterten Phasentrunkierung erzeugen. Vorliegend sind die Direct-Digital-Synthesizer 5 in den Frequenzsynthesizern 1 so ausgestaltet, dass sie einen n-Bit Phasenakkumulator und einen von dem Phasenakkumulator angesteuerten Phasenspeicher umfassen, wobei der Phasenakkumulator mit einem n-Bit Sprungwort parametrierbar ist. Der Phasenakkumulator wird getaktet betrieben und stellt im Wesentlichen nichts anderes als einen Zähler dar, wobei das Sprungwort zur Parametrierung des Phasenakkumulators vorgibt, wieviele Zählerstellen bei einem Zählimpuls übersprungen werden, so dass der Phasenakkumulator zusammen mit dem vorgebbaren Sprungwort nichts anderes als ein n-Bit variabler Modulus-Zähler ist.

Der Phasenspeicher enthält idealerweise so viele Amplitudenwerte des zu erzeugenden Frequenzsignals wie der Phasenakkumulator Zählerstände aufweist, wobei gegebenenfalls die Symmetrie des zu erzeugenden Frequenzsignals ausgenutzt werden kann. Vorliegend werden jedoch nur die m MSBs des Phasenakkumulators zur Ansteuerung des Phasenspeichers genutzt, was dem Grunde nach bei vielen Direct-Digital-Synthesizern 5 üblich ist, damit der Phasenspeicher auf eine vernünftige Größe beschränkt ist. Vorliegend ist das n-Bit Sprungwort so ausgewählt, dass es an der Bitposition (n-m) eine 1 aufweist und an allen niedrigeren Bitpositionen eine Null aufweist. Ein derart gewähltes Sprungwort garantiert, dass keine periodischen Fehler bei der Erzeugung des durch den Direct-Digital-Synthesizer 5 generierten Frequenzsignals kommt, wodurch auch keine mit den periodischen Fehlern zwingend korrespondierenden Störlinien im Amplitudenspektrum des Frequenzsynthesizers bzw. des Direct-Digital-Synthesizers 5 des Frequenzsynthesizers 1 erzeugt werden. Aus dem Bildegesetz zur Wahl eines geeigneten Sprungwortes ist ersichtlich, dass es praktisch unmöglich ist, unter Einsatz - wie aus dem Stand der Technik bekannt - zweier Direct-Digital-Synthesizer 5 Frequenzsignale zu erzeugen, die nur mit wenigen Hertz beabstandet sind und gleichzeitig keine Störlinien aufgrund Phasentrunkierung aufweisen.

Bei dem Ausführungsbeispiel gemäß Fig. 1 ist zunächst ein erster Frequenzteiler 6 zwischen dem Direct-Digital-Synthesizer 5 und dem ersten Ausgang 2 vorgesehen, vorliegend ist der erste Ausgang 2 mit dem Ausgangssignal des ersten Frequenzteilers 6 beaufschlagbar, was jedoch nicht zwingend erforderlich ist. Durch den ersten Frequenzteiler 6 besteht die zusätzliche Möglichkeit, die Frequenz des Frequenzsignals einzustellen, das über den ersten Ausgang 2 des Frequenzsynthesizers 1 ausgebbar ist. Ein großer Vorteil liegt aber auch darin, dass der Frequenzsynthesizer 1 und damit der vor dem ersten Ausgang 2 vorgelagerte Direct-Digital-Synthesizer 5 bei einer hohen Frequenz betrieben werden und ein niederfrequenteres Ausgangssignal durch den ersten Frequenzteiler 6 erzeugt wird, weil der Frequenzteiler zu einem zusätzlichen Störlinienabstand führt, so dass insgesamt durch die Kombination von hochfrequent betriebenem Direct-Digital-Synthesizer 5 mit dem ersten Frequenzteiler 6 ein verbessertes Signal-Rausch-Verhältnis realisiert wird. Die gleichen Vorteile bringt auch der erste Frequenzteiler 6 in der Schaltung gemäß Fig. 2 mit sich in Kombination mit dem prinzipiell auch dort vorgelagerten Direct-Digital-Synthesizer 5.

Beide Schaltungen zeichnen sich auch dadurch aus, dass zusätzlich ein zweiter Frequenzteiler 7 zwischen dem Referenzoszillator 4 und dem zweiten Ausgang 3 vorgesehen ist, vorliegend nämlich insbesondere so, dass der zweite Ausgang 3 mit dem Ausgangssignal des zweiten Frequenzteilers 7 beaufschlagt wird. Auch durch den zweiten Frequenzteiler 7 wird ein weiterer Freiheitsgrad für die Einstellung der Differenzfrequenz sowie ein zusätzlicher Störlinienabstand gewonnen. Für die mit der Schaltung gemäß Fig. 1 erzielte Differenzfrequenz gilt:

$$\Delta f = \left| f_2 - f_1 \right| = \left| \frac{f_{ref}}{N} - \frac{f_{DDS1}}{M} \right| \qquad (2)$$

Dabei ist $f_{ref}$ die Frequenz des Referenzfrequenzsignals, das von dem Referenzoszillator 4 ausgegeben wird.

Bei Kehrlage- bzw. Gleichlagemischung des Ausgangssignals des Direct-Digital-Synthesizers 5 mit dem Referenzfrequenzsignal und anschließendem Herunterteilen des gemischten Signals durch den ersten Frequenzteiler 6 gilt für die erzielte Differenzfrequenz:

$$\Delta f = \left| f_2 - f_1 \right| = \left| \frac{f_{ref}}{N} - \frac{f_{ref} \pm f_{DDS}}{M} \right| \qquad (3)$$

Gleichung 3 macht die weit reichenden Gestaltungsmöglichkeiten bei der Einstellung einer geeigneten Differenzfrequenz Δf deutlich.

Es hat sich als vorteilhaft erwiesen, wie in den Fig. 1 und 2 auch dargestellt, wenn zwischen dem Ausgang des Direct-Digital-Synthesizers 5 und dem ersten Ausgang 2 des Frequenzsynthesizers 1 ein erster Filter 8 vorgesehen ist, wobei der erste Filter 8 vorliegend als Bandpass ausgestaltet ist. In Fig. 1 ist der erste Filter 8 dem Direct-Digital-Synthesizer 5 und dem ersten Frequenzteiler 6 zwischengeschaltet, so dass das Ausgangssignal des ersten Filters 8

den ersten Frequenzteiler 6 dort beaufschlagt. Durch den als Bandpass ausgestalteten ersten Filter 8 werden die vom eigentlichen Ausgangssignal des Direct-Digital-Synthesizers 5 frequenzmäßig entfernten Störsignale ausgeblendet.

Bei dem Ausführungsbeispiel gemäß Fig. 2 ist zwischen dem ersten Direct-Digital-Synthesizer 5 und dem ersten Ausgang 2 ferner ein Mischer 9 vorgesehen, wobei ein erster Eingang des Mischers 9 zumindest mittelbar mit dem Ausgangssignal des ersten Direct-Digital-Synthesizers 5 beaufschlagbar ist und ein zweiter Eingang des Mischers 9 zumindest mittelbar mit dem Ausgangssignal des Referenzoszillators 4 beaufschlagbar ist und der erste Ausgang 2 zumindest mittelbar mit dem Ausgangssignal des Mischers 9 beaufschlagt ist. Dieser Mischer 9 besteht vorliegend aus einem Multiplikationsglied, das die Eingangssignale im Zeitbereich miteinander multipliziert, wobei dadurch insgesamt eine Frequenzumsetzung der Eingangssignale bewirkt wird. Bei anderen hier nicht dargestellten Ausführungsbeispielen wird die Signalmischung durch interne Nichtlinearitäten erzielt, womit im Ergebnis jedoch der gleiche Effekt erzielbar ist.

Durch den Mischer 9 und die damit hervorgerufene Frequenzumsetzung - beispielsweise Frequenzheraufsetzung / Hochmischung - wird ein weiterer Freiheitsgrad bei der Wahl des zum Einsatz kommenden Referenzoszillators 4 und der zum Einsatz kommenden Frequenzteiler 6, 7 und Filter 8 sowie der Parametrierung des Direct-Digital-Synthesizers 5 bewirkt. Dadurch können beim Direct-Digital-Synthesizer 5 beispielsweise weitere günstige Frequenzen im Sinne störlinienfreier Phasentrunkierung eingestellt werden, wobei zusätzlich der Vorteil erzielt wird, dass mit dem Hochmischen keine Verschlechterung des Phasenrauschens einhergeht, durch die anschließende Frequenzteilung jedoch eine Reduzierung des Phasenrauschens erzielt wird, so dass die mit der dargestellten Schaltung erzielbaren Frequenzsignale ein hohes Signal-zu-Rausch-Verhältnis aufweisen, die beispielsweise mit Schaltungen unter Verwendung zweier Direct-Digital-Synthesizer nicht realisierbar sind.

Bei dem Frequenzsynthesizer 1 gemäß Fig. 2, bei dem der Mischer 9 zwischen dem Ausgang des ersten Filters 8 und dem Eingang des ersten Frequenzteilers 6 vorgesehen ist, ergibt sich die serielle Anordnung Direct-Digital-Synthesizer 5, erster Filter 8, Mischer 9, erster Frequenzteiler 6 und erster Ausgang 2.

Störsignale, insbesondere im Ausgang des Mischers 9, lassen sich durch einen zweiten Filter 10 zwischen dem Ausgang des Referenzoszillators 4 und dem zweiten Eingang des Mischers 9 unterdrücken, wobei der zweite Filter 10 ebenfalls als Bandpass ausgestaltet ist, wie in Fig. 2 dargestellt.

**Patentansprüche**

1. Frequenzsynthesizer, insbesondere für einen Zeitbasisgenerator eines Füllstandsmessgeräts, das nach dem Radarprinzip arbeitet, mit wenigstens einem ersten Ausgang (2) zur Ausgabe eines ersten Frequenzsignals, mit wenigstens einem zweiten Ausgang (3) zur Ausgabe eines zweiten Frequenzsignals, und mit einem Referenzoszillator (4) zur Erzeugung eines Referenzfrequenzsignals, wobei das erste Frequenzsignal und das zweite Frequenzsignal eine geringe Differenzfrequenz zueinander aufweisen, wobei das erste Frequenzsignal durch Zusammenwirken des Referenzoszillators (4) mit einem Direct-Digital-Synthesizer (5) erzeugbar ist,
**dadurch gekennzeichnet,**
**dass** das zweite Frequenzsignal von dem Referenzoszillator (4) ohne Zwischenschaltung eines Direct-Digital-Synthesizers abgeleitet ist und der Direct-Digital-Synthesizer (5) so betrieben ist, dass nur ein zumindest partiell minimiertes Störspektrum erzeugt wird.

2. Frequenzsynthesizer nach Anspruch 1, **dadurch gekennzeichnet, dass** ein von dem Direct-Digital-Synthesizer (5) umfasster Digital/Analog-Wandler bei maximaler Auflösung betrieben wird.

3. Frequenzsynthesizer nach Anspruch 1 oder 2, **dadurch gekennzeichnet, dass** der von dem Direct-Digital-Synthesizer (5) umfasste Digital/AnalogWandler bei einer Frequenz in Überabtastung betrieben wird, insbesondere bei maximaler Frequenz betrieben wird.

4. Frequenzsynthesizer nach einem der Ansprüche 1 bis 3, **dadurch gekennzeichnet, dass** der Direct-Digital-Synthesizer (5) mit solchen Phasensprüngen betrieben wird, die keine Störlinien aufgrund Phasentrunkierung erzeugen.

5. Frequenzsynthesizer nach Anspruch 4, **dadurch gekennzeichnet, dass** der Direct-Digital-Synthesizer (5) einen n-Bit Phasenakkumulator und einen von dem Phasenakkumulator angesteuerten Phasenspeicher umfasst, wobei der Phasenakkumulator mit einem n-Bit Sprungwort parametrierbar ist, wobei nur die m Most-Significant-Bits (MSBs) des Phasenakkumulators zur Ansteuerung des Phasenspeichers genutzt werden, wobei das n-Bit Sprungwort an der Bitposition (n-m) eine 1 aufweist und wobei alle niedrigeren Bitpositionen des Sprungwortes eine 0 aufweisen.

6. Frequenzsynthesizer nach einem der Ansprüche 1 bis 5, **dadurch gekennzeichnet, dass** der Direct-Digital-Synthesizer (5) bei maximaler Frequenz betrieben wird.

7. Frequenzsynthesizer nach einem der Ansprüche 1 bis 6, **dadurch gekennzeichnet, dass** ein erster Frequenzteiler (6) zwischen dem Direct-Digital-Synthesizer (5) und dem ersten Ausgang (2) vorgesehen ist, insbesondere so dass der erste Ausgang (2) mit dem Ausgangssignal des ersten Frequenzteilers (6) beaufschlagbar ist.

8. Frequenzsynthesizer nach einem der Ansprüche 1 bis 7, **dadurch gekennzeichnet, dass** ein zweiter Frequenzteiler (7) zwischen dem Referenzoszillator (4) und dem zweiten Ausgang (3) vorgesehen ist, insbesondere so dass der zweite Ausgang (3) mit dem Ausgangssignal des zweiten Frequenzteilers (7) beaufschlagbar ist.

9. Frequenzsynthesizer nach einem der Ansprüche 1 bis 8, **dadurch gekennzeichnet, dass** zwischen dem Ausgang des Direct-Digital-Synthesizers (5) und dem ersten Ausgang (2) des Frequenzsynthesizers (1) ein erster Filter (8) vorgesehen ist, insbesondere wobei der erste Filter (8) als Bandpass ausgestaltet ist, insbesondere wobei das Ausgangssignal des ersten Filters (8) den ersten Frequenzteiler (6) beaufschlagt.

10. Frequenzsynthesizer nach Anspruch 9, **dadurch gekennzeichnet, dass** der Direct-Digital-Synthesizer (5) mit solchen Phasensprüngen betrieben wird, die nur solche Störlinien aufgrund Phasentrunkierung erzeugen, die in den Sperrbereich des dem Direct-Digital-Synthesizer (5) nachgeschalteten Bandpasses (8) fallen.

11. Frequenzsynthesizer nach einem der Ansprüche 1 bis 10, **dadurch gekennzeichnet, dass** zwischen dem ersten Direct-Digital-Synthesizer (5) und dem ersten Ausgang (2) ein Mischer (9) vorgesehen ist, wobei ein erster Eingang des Mischers (9) zumindest mittelbar mit dem Ausgangssignal des ersten Direct-Digital-Synthesizers (5) beaufschlagbar ist und ein zweiter Eingang des Mischers (9) zumindest mittelbar mit dem Ausgangssignal des Referenzoszillators (4) beaufschlagbar ist und der erste Ausgang (2) zumindest mittelbar mit dem Ausgangssignal des Mischers (9) beaufschlagbar ist.

12. Frequenzsynthesizer nach Anspruch 11, **dadurch gekennzeichnet, dass** der Mischer (9) zwischen dem Ausgang des ersten Filters (8) und dem Eingang des ersten Frequenzteilers (6) vorgesehen ist, insbesondere wobei sich die serielle Anordnung Direct-Digital-Synthesizer (5), erster Filter (8), Mischer (9), erster Frequenzteiler (6) und erster Ausgang (2) ergibt.

13. Frequenzsynthesizer nach Anspruch 11 oder 12, **dadurch gekennzeichnet, dass** zwischen dem Ausgang des Referenzoszillators (4) und dem zweiten Eingang des Mischers (9) ein zweiter Filter (10) vorgesehen ist, wobei der zweite Filter (10) insbesondere als Bandpass ausgestaltet ist.

14. Füllstandsmessgerät, das nach dem Radarprinzip arbeitet mit einem Frequenzsynthesizer (5) zur Erzeugung eines ersten Frequenzsignals - Abtastsignal - und zur Erzeugung eines zweiten Frequenzsignals - Sendesignal - **dadurch gekennzeichnet,**
**dass** der Frequenzsynthesizer (5) nach einem der Ansprüche 1 bis 13 ausgestaltet ist.

Fig. 1

Fig. 2

<table>
<tr><td>Europäisches<br>Patentamt<br>European<br>Patent Office<br>Office européen<br>des brevets</td><td>**EUROPÄISCHER RECHERCHENBERICHT**</td><td>**Nummer der Anmeldung**<br><br>EP 10 00 6872</td></tr>
</table>

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X<br><br>Y | US 2007/192391 A1 (MCEWAN THOMAS E [US])<br>16. August 2007 (2007-08-16)<br>* Absätze [0005], [0011] - [0046];<br>Abbildungen 1,4,7 *<br>----- | 1-10,14<br><br>11-13 | INV.<br>G06F1/03<br>H03B21/02 |
| Y | GB 1 348 221 A (MARCONI CO LTD)<br>13. März 1974 (1974-03-13)<br>* das ganze Dokument *<br>----- | 11-13 | |

RECHERCHIERTE
SACHGEBIETE (IPC)

G06F
H03B

Der vorliegende Recherchenbericht wurde für alle Patentansprüche erstellt

| Recherchenort | Abschlußdatum der Recherche | Prüfer |
|---|---|---|
| München | 4. Oktober 2010 | Waters, Duncan |

EPO FORM 1503 03.82 (P04C03)

EP 2 280 330 A1

**ANHANG ZUM EUROPÄISCHEN RECHERCHENBERICHT**
**ÜBER DIE EUROPÄISCHE PATENTANMELDUNG NR.**

EP 10 00 6872

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-10-2010

| Im Recherchenbericht angeführtes Patentdokument | Datum der Veröffentlichung | Mitglied(er) der Patentfamilie | Datum der Veröffentlichung |
|---|---|---|---|
| US 2007192391 A1 | 16-08-2007 | KEINE | |
| GB 1348221 A | 13-03-1974 | AU 470070 B2 | 04-03-1976 |
| | | AU 5485973 A | 31-10-1974 |

EPO FORM P0461

Für nähere Einzelheiten zu diesem Anhang : siehe Amtsblatt des Europäischen Patentamts, Nr.12/82